# EUROPÄISCHE PATENTANMELDUNG

(11) **EP 4 446 461 A1**
(43) Veröffentlichungstag der Anmeldung: **16.10.2024**
(21) Anmeldenummer: 24160934.6
(22) Anmeldetag: 01.03.2024
(51) Int. Cl.: C23C 16/04, B65G 47/84, B67C 3/24, C23C 16/54, C23C 30/00

(54) **BESCHICHTUNGSANLAGE ZUM BESCHICHTEN VON BEHÄLTERN**

(30) Priorität: 27.03.2023 DE 102023107641
(71) Anmelder: KHS GmbH, 44143 Dortmund (DE)
(72) Erfinder: Brzezinski, Milosz, 23863 Bargfeld-Stegen (DE)
(74) Vertreter: Andrejewski - Honke Patent- und Rechtsanwälte Partnerschaft mbB

(57) **Zusammenfassung**

Die Erfindung betrifft eine Beschichtungsanlage mit einer Beschichtungsvorrichtung, welche ein rotierbar antreibbares Beschichtungsrad (1) sowie eine vorgelagerte Einlaufanordnung (2) und eine dem Beschichtungsrad (1) nachgelagerte Auslaufanordnung (3) aufweist, welche gemeinsam dazu eingerichtet sind, Behälter (6) jeweils entlang eines Abschnittes einer Transportstrecke zu transportieren, wobei das Beschichtungsrad (1) eine Vielzahl von in Umfangsrichtung angeordneten Behälteraufnahmen (5) und jeweils eine den Behälteraufnahmen (5) zugeordnete Beschichtungseinheit (4) aufweist, wobei die Beschichtungseinheit (4) dazu eingerichtet ist, die Behälter (6) während des Transports zu beschichten und wobei entlang der Transportstrecke zumindest ein Leitelement vorgesehen ist. Erfindungsgemäß weist das Leitelement zumindest abschnittsweise eine Keramikbeschichtung auf.

## Beschreibung

Die Erfindung betrifft eine Beschichtungsanlage mit einer Beschichtungsvorrichtung, welche ein rotierbar antreibbares Beschichtungsrad sowie eine vorgelagerte Einlaufanordnung und eine dem Beschichtungsrad nachgelagerte Auslaufanordnung aufweist, welche gemeinsam dazu eingerichtet sind, Behälter jeweils entlang eines Abschnittes einer Transportstrecke zu transportieren, wobei das Beschichtungsrad eine Vielzahl von in Umfangsrichtung angeordneten Behälteraufnahmen und jeweils eine den Behälteraufnahmen zugeordnete Beschichtungseinheit aufweist, wobei die Beschichtungseinheit dazu eingerichtet ist, die Behälter während des Transports zu beschichten und wobei entlang der Transportstrecke zumindest ein Leitelement vorgesehen ist.

Derartige Behälterbeschichtungsanlagen sind grundsätzlich aus dem Stand der Technik bekannt und dienen dazu, Behälter mit einer Innenbeschichtung zu versehen. Die Erfindung bezieht sich insbesondere auf Behälter aus dem Bereich der Lebensmitteltechnik, insbesondere der Getränketechnik. Entsprechend handelt es sich bei den Behältern um Getränkebehälter, beispielsweise um Getränkeflaschen. Die Getränkebehälter bestehen insbesondere aus Kunststoff z.B. aus Polyethylenterephthalat (PET) und werden vor der Beschichtung üblicherweise im Rahmen einer Blasumformung aus Vorformlingen ausgeformt.

Da insbesondere Polyethylenterephthalat nur geringe Barriereeigenschaften gegen das Eindringen von Sauerstoff und/oder das Austreten von Kohlendioxid oder anderen Gasen aufweist, kann mithilfe einer entsprechenden Beschichtungsanlage eine zusätzliche Barriereschicht innenliegend auf die Behälterwandungen aufgebracht werden.

Eine solche Beschichtung erfolgt üblicherweise mithilfe sogenannter Plasmabeschichtungsverfahren, wobei aus einem Plasma heraus die entsprechenden Schichten abgeschieden werden und sich auf den Wandungen des Getränkebehälters absetzen. In diesem Zusammenhang ist auch von sogenannten PICVD-Verfahren ("Plasma Impuls Chemical Vapor Deposition") die Rede, wobei insbesondere Schichten aus Siliziumoxid abgeschieden werden. Entsprechende Verfahren sind zum Beispiel aus der WO 03/100125 A1 und aus der WO 03/100121 A2 bekannt.

Die Beschichtung der Behälter erfolgt im Beschichtungsrad. Hierzu weist das Beschichtungsrad eine Vielzahl von Beschichtungseinheiten auf, welche üblicherweise gemeinsam mit der zugeordneten Behälterausformung ausgebildet sind. Während der Beschichtung werden die Behälter innerhalb der Behälteraufnahmen zunächst evakuiert und sodann durch Einbringen verschiedener Gase die entsprechende Barriereschicht aus dem Plasma abgeschieden.

In modernen Abfüllanlagen sind die Beschichtungsanlagen Teil einer sogenannten verblockten Anlage. Dies bedeutet, dass die einzelnen Behandlungsanlagen unmittelbar über sogenannte Transfersterne miteinander in Verbindung stehen, sodass entsprechend die Behälter unmittelbar von einer Anlagenkomponente an eine weitere Anlagenkomponente übergeben werden.

Entsprechend weist die Beschichtungsanlage eine Einlaufanordnung auf, über welche die Behälter in das Beschichtungsrad eingeführt und eine Auslaufanordnung auf, über welchen die Behälter aus dem Beschichtungsrad entnommen und an eine weitere Anlagenkomponente geleitet werden. Dabei ist es üblich, dass die Behälter über entsprechende Leitelemente geführt werden können. Entsprechend handelt es sich bei den Leitelementen um Bauteile der Beschichtungsanlage, an denen die Behälter entlanggeleiten und somit eine Relativgeschwindigkeit aufweisen. Aufgrund der hierbei wirkenden Haftreibung kann diese Relativgeschwindigkeit einen Materialabtrag der Behälter bewirken. Dieser Materialabtrag ist zwar mengenmäßig gering und bedeutet keinen wesentlichen Materialverlust für die Behälter. Dennoch bilden sich sehr kleine Partikel insbesondere aus PET, welche sich an den einzelnen Leitelementen und damit innerhalb der Beschichtungsanlage ablagern.

Hierbei ist es gerade im Rahmen einer Beschichtungsanlage von besonderer Problematik, dass das Beschichtungsrad gemäß einer üblichen Ausgestaltung mit einem Vakuumerzeuger in Verbindung steht, wobei die Beschichtungseinheiten über diesen Vakuumerzeuger vor dem Einbringen des Plasmas die Behälter evakuieren. Dieser Unterdruck kann dazu führen, dass die abgetragenen Partikel in den Behälter gelangen und den Beschichtungsprozess stören. Vor diesem Hintergrund ist es erforderlich, die Partikel entweder regelmäßig zu entfernen oder aber den Materialabtrag mengenmäßig zu begrenzen.

Die Entfernung der Partikel ist hierbei sehr aufwendig und zeitraubend, insbesondere da die Partikel elektrostatisch an den Oberflächen anhaften, sodass für einen Abtrag einerseits auf eine große Saugleistung und andererseits auf eine geringe Entfernung zwischen Sauger und Partikel zurückgegriffen werden muss. Hierbei setzt die Zugänglichkeit der einzelnen Leitelemente jedoch Grenzen.

Alternativ wurde in der Praxis vorgeschlagen, einzelne Leitelemente mit Silikonölen zu versehen. Allerdings werden diese Silikonöle mit den Behältern mitgeschleppt und können so in das Beschichtungsrat gelangen. Aufgrund der Schicht aus Silikonöl ist dann keine Beschichtung des Behälters mehr möglich.

Vor diesem Hintergrund liegt der Erfindung die Aufgabe zugrunde, den Materialabtrag der Behälter innerhalb der Beschichtungsanlage zu reduzieren und zugleich eine zuverlässige Beschichtung der Behälter zu ermöglichen. Zugleich soll die erforderliche Wartungszeit gering gehalten werden.

Lösung dieser Aufgabe und Gegenstand der Erfindung ist eine Beschichtungsanlage gemäß Patentanspruch 1. Dementsprechend ist vorgesehen, dass das Leitelement zumindest abschnittsweise eine Keramikbeschichtung aufweist. Mithilfe dieser Keramikbeschichtung wird die Oberfläche des Leitelementes derart gehärtet, dass sich der Haftreibungskoeffizient zwischen dem Leitelement bzw. dessen Oberfläche und einem entlanggleitenden Objekt reduziert. Entsprechend bildet sich ein Effekt aus, wie er auch durch Verwendung von Silikonölen erzielt wird. Allerdings können sich keine Stoffe auf den Behältern absetzen, welche eine Beschichtung innerhalb des Beschichtungsrades verhindern.

Besonders bevorzugt ist es in diesem Zusammenhang, wenn nicht nur ein Leitelement sondern mehrere Leitelemente entlang der Transportstrecke vor gesehen sind, welche zumindest abschnittsweise eine Keramikbeschichtung aufweisen. Besonders bevorzugt weisen alle Leitelemente eine entsprechende zumindest abschnittsweise Keramikbeschichtung auf, sodass insgesamt der Materialabtrag der Behälter begrenzt werden kann.

In diesem Zusammenhang sieht eine besonders bevorzugte Ausgestaltung vor, dass das Leitelement bzw. dass die Leitelemente jeweils zumindest eine Anlagefläche zum Leiten der Behälter aufweisen und wobei die Keramikbeschichtung zumindest auf der Anlagefläche, insbesondere vollflächig, angeordnet ist. Entsprechend ist es grundsätzlich ausreichend, wenn lediglich im Bereich der Anlagefläche eine entsprechende Keramikbeschichtung vorgesehen ist. Allerdings kann es aufgrund des Fertigungsprozesses auch sinnvoll sein, das zu beschichtende Leitelement vollflächig mit einer Keramikbeschichtung zu versehen. Eine solche Ausgestaltung kann aber auch selbstverständlich vorsehen, dass einzelne Bereiche ausgespart werden, z. B. in Bereichen in denen eine Bohrung vorgesehen ist.

Wie bereits zuvor erläutert, umfasst der Begriff Leitelement sämtliche Bauteile innerhalb der Beschichtungsanlage, welche einerseits die Bewegung der Behälter in irgendeiner Form beeinflussen und andererseits an denen die Behälter entlanggleiten. Entsprechend kann zumindest ein Leitelement als Führungsschiene zum Führen der Behälter entlang eines Abschnittes der Transportstrecke ausgebildet sein. Eine solche Führungsschiene kann beispielsweise eine vertikale Wandung darstellen, entlang der die Behälter geführt werden. Besonders bevorzugt handelt es sich hierbei aber um eine horizontale Wandung, auf der die Behälter mit einem Behälterabschnitt aufliegen. Bei diesem Behälterabschnitt handelt es sich insbesondere um den Neckring handeln. Dieser Neckring ist Teil des Kopfbereiches der Behälter und üblicherweise unmittelbar unter dem Außengewinde angeordnet, welcher für das Aufschrauben einer Verschlusskappe dient. Dieser Neckring steht gegenüber dem Gewinde vor und eignet sich daher besonders gut, um die Behälter innerhalb der Beschichtungsanlage zu führen. Entsprechend kann durch Anordnung der Führungsschiene entlang einer horizontalen Richtung der Behälter mit dem Neckring auf dieser Führungsschiene gleiten, sodass der Materialabtrag im Wesentlichen am Neckring erfolgt. Entsprechend weist die Führungsschiene dann zumindest in dem Bereich eine Keramikbeschichtung auf, an welchem der Neckring entlang geführt wird. Insbesondere kann es ausreichend sein, lediglich auf der oberen Seite der Führungsschiene eine entsprechende Keramikbeschichtung vorzusehen.

Eine Weiterbildung sieht in diesem Zusammenhang auch vor, dass zwei zueinander beabstandete Führungsschienen entlang des Abschnittes der Transportstrecke angeordnet sind. Auch hierbei können beide Führungsschienen grundsätzlich horizontal ausgerichtet sein und der beidseitigen Abstützung des Behälters durch den Neckring dienen. Entsprechend bilden beide Führungsschienen einen Spalt, durch welchen sich der Behälter erstreckt. Alternativ kann es sich aber auch um zwei seitliche Wandungen handeln, an denen der Behälter mit dem Behälterkörper anliegt.

Ausgehend von einer solchen Ausgestaltung kann dann das als Führungsschiene ausgebildete Leitelement in einem Abschnitt der Transportstrecke in der Einlaufanordnung und/oder in der Auslaufanordnung angeordnet sein.

Ergänzend oder alternativ ist es darüber hinaus auch möglich, dass zumindest ein Leitelement als Überführungselement zum Ein- oder Ausweisen von Behältern ausgebildet ist. Entsprechend dient das Leitelement dazu, die Behälter zwischen zwei aneinander angrenzenden Anlagenkomponenten zu überführen.

Beispielsweise können mithilfe entsprechender Überführungselemente die Behälter aus passiven Greifern herausgelöst werden. Bei derartigen passiven Greifern werden die Behälter über federbelastete Greifer gehalten, wobei allerdings keine aktive Bewegung der Greiferzangen erfolgt. Vielmehr werden die Behälter durch Überwinden der Federkraft in die Greifer hinein- oder herausgedrückt. Dies erfolgt mithilfe der zuvor genannten Überführungselemente. Entsprechend können beispielsweise entsprechende Greifer sowohl innerhalb der Einlauf- als auch der Auslaufanordnung vorgesehen sein. Auch im Beschichtungsrad können die Behälter mithilfe von passiven Greifern gehalten werden. Die Überleitelemente können dann so ausgebildet sein, dass sie einen quer zur Transportrichtung vorstehenden Abschnitt aufweisen, welcher durch Aufbringen einer Querkraft die Behälter in die passiven Greifer hinein- oder herausdrückt.

Entsprechend ist das als Überführungselement ausgebildete Leitelement zwischen dem Beschichtungsrad und der Einlaufanordnung oder der Auslaufanordnung angeordnet.

Darüber hinaus können die Einlaufanordnung und/oder die Auslaufanordnung aus jeweils zumindest zwei hintereinander entlang der Transportstrecke angeordneten Transportsternen gebildet sein. Gemäß einer solchen Ausgestaltung wird dann der unmittelbar an das Beschichtungsrad angrenzende Transportstern der Einlauf- und der Auslaufanordnung als Einlaufstern oder als Auslaufstern bezeichnet. Über den Einlaufstern erfolgt das Einbringen in das Beschichtungsrad und über den Auslaufstern das Ausbringen der Behälter. Ausgehend von einer solchen Ausgestaltung kann dann das Überführungselement zwischen dem Einlaufstern und dem Beschichtungsrad, dem Auslaufstern und dem Beschichtungsrad oder zwischen den Transportsternen der Einlauf- und/oder der Auslaufanordnung angeordnet sein.

Eine Weiterbildung der Erfindung sieht ferner vor, dass das zumindest eine Leitelement aus Edelstahl und/oder Aluminium gebildet ist. Darüber hinaus kann es zweckmäßig sein, das Leitelement vor dem Beschichten zu polieren.

Bei der Keramikbeschichtung handelt es sich bevorzugt um eine Keramikbeschichtung aus Chromnitrid.

Gemäß einer bevorzugten Weiterbildung weist die Keramikbeschichtung eine Dicke zwischen 5 und 15 µm auf.

Im Folgenden wird die Erfindung anhand eines Ausführungsbeispiels, näher erläutert. Es zeigen:
- Fig. 1: eine Draufsicht der schematischen Darstellung einer erfindungsgemäßen Beschichtungsanlage
- Fig. 2: eine Darstellung der Auslaufanordnung mit erfindungsgemäßen Leitelementen
- Fig. 3: ein Ausschnitt aus der Fig. 2 mit detaillierter Darstellung der Leitelemente.

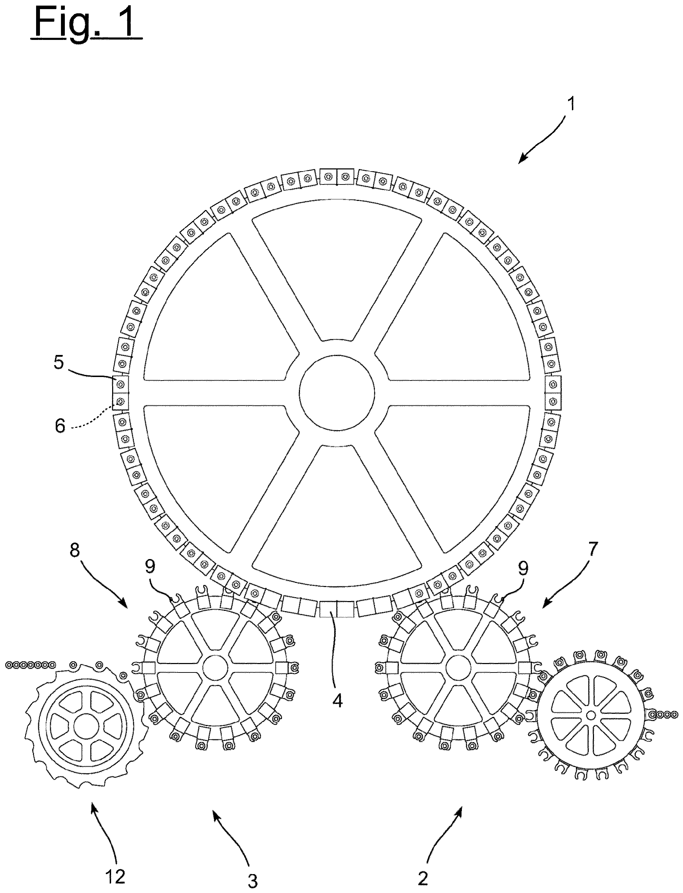

Die Fig. 1 zeigt eine erfindungsgemäße Beschichtungsanlage, welche als Behälterbeschichtungsanlage ausgebildet ist, wobei es sich bei den Behältern 6 in bevorzugter Weise um Getränkeflaschen aus Kunststoff, insbesondere aus Polyethylenterephthalat, handelt.

Die Beschichtungsanlage weist ein rotierbar antreibbares Beschichtungsrad 1 sowie eine vorgelagerte Einlaufanordnung 2 und eine nachgeschaltete Auslaufanordnung 3 auf. Das Beschichtungsrad 1 selbst weist wiederum eine Vielzahl von in Umfangsrichtung angeordneten Beschichtungseinheiten 4 sowie den Beschichtungseinheiten 4 zugeordnete Behälteraufnahmen 5 auf, wobei die in den Behälteraufnahmen 5 angeordneten Behälter 6 über die Beschichtungseinheiten 4 innenliegend beschichtet werden. Hierzu wird über die Beschichtungseinheiten 4 ein Plasma erzeugt, über das sich eine Barriereschicht auf den Innenwänden der Behälter 6 abscheidet.

Sowohl die Einlaufanordnung 2 als auch die Auslaufanordnung 3 sind jeweils als Transportsternanordnung ausgebildet, wobei ein Einlaufstern 7 und ein Auslaufstern 8 unmittelbar an das Beschichtungsrad 1 angrenzen und wobei über den Einlaufstern 7 die Behälter 6 zugeführt und über den Auslaufstern 8 entnommen werden. Hierzu weisen sowohl der Einlaufstern 7 als auch der Auslaufstern 8 passive Greifer 9 auf, welche die Behälter 6 im Bereich eines Neckringes 10 greifen und über eine Beaufschlagung mit einer Feder innerhalb der Greifer 9 halten. Entsprechend müssen Leitelemente vorgesehen sein, welche das Einführen und das Ausführen der Behälter 6 in die passiven Greifer bzw. aus dem passiven Greifer 9 heraus ermöglichen.

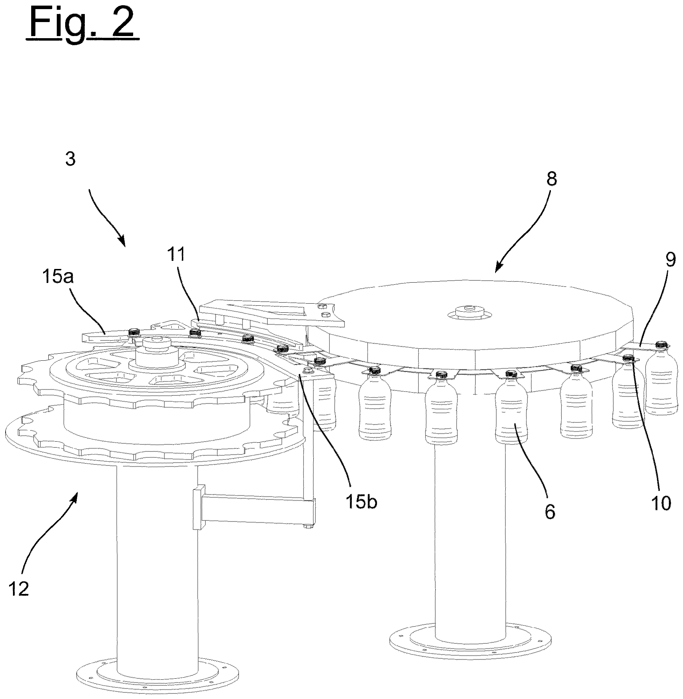

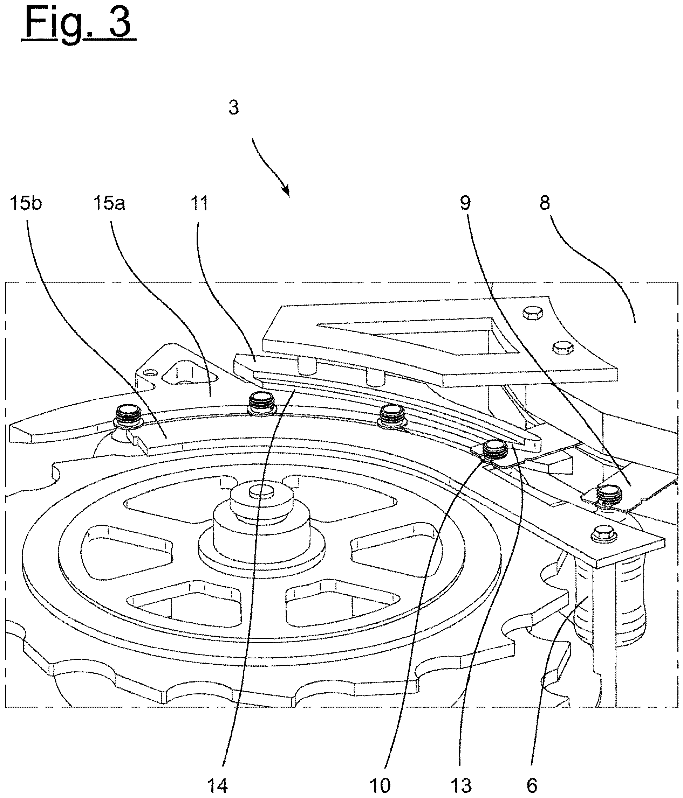

In diesem Zusammenhang zeigen die Fig. 2 und 3 jeweils einen Ausschnitt der Beschichtungsanlage im Bereich der Auslaufanordnung 2. Wie bereits zuvor erläutert, weist der Auslaufstern 8 eine Vielzahl von in Umfangsrichtung 9 angeordneten passiven Greifern 9 auf, welche die Behälter 6 halten. Anhand der Fig. 2 und 3 ist nunmehr ein als Überführungselement 11 vorgesehenes Leitelement zwischen dem Auslaufstern 9 und dem nachgelagerten Transportstern 12 vorgesehen, welches die Behälter 6 aus dem Greifer 9 herausdrückt. Hierbei gleitet der Behälter 6 an dem Überführungselement 11 entlang und wird durch einen bauchigen Vorsprung 13 quer zur Transportstrecke mit einer Kraft beaufschlagt, welche ausreicht, um den Behälter 6 aus dem Greifer 9 herauszudrücken.

Hierbei ist es allerdings problematisch, dass der Behälter 6 zumindest abschnittsweise entlang einer Anlagefläche 14 des Überführungselementes 11 gleitet, wobei die Reibung dazu führt, dass Material vom Behälter 6 abgetragen wird und sich in Form von feinen Partikeln in der Beschichtungsanlage absetzt.

Vor diesem Hintergrund ist vorgesehen, dass das als Überführungselement 11 ausgebildete Leitelement eine Keramikbeschichtung aufweist. In dem gezeigten Beispiel sind sämtliche Oberflächen mit einer entsprechenden Keramikbeschichtung versehen, wobei es allerdings auch ausreichend ist, wenn lediglich die Anlagefläche 14 eine entsprechende Keramikbeschichtung aufweist.

Darüber hinaus sind auch Führungsschienen 15a, 15b vorgesehen, über welche der Behälter 6 zumindest über ein Abschnitt des Transportweges entlang des dem Auslaufstern 8 nachgeschalteten Transportstern 12 bewegt wird. Hierbei gleitet der Behälter 6 mit dem Neckring 10 entlang der Führungsschienen 15a, 15b, sodass auch hier ein entsprechender Materialabtrag hervorgerufen wird. Vor diesem Hintergrund weisen auch die als Führungsschienen 15a, 15b ausgebildeten Leitelemente eine Keramikbeschichtung auf.

Bei der Keramikbeschichtung handelt es sich um eine Beschichtung aus Chromnitrid mit eine Dicke zwischen 5 und 15 µm. Die Leitelemente sind aus Edelstahl oder Aluminium gefertigt und wurden vor dem Beschichten mit Keramik poliert.

### Bezugszeichenliste

- 1: Beschichtungsrad
- 2: Einlaufanordnung
- 3: Auslaufanordnung
- 4: Beschichtungseinheiten
- 5: Behälteraufnahmen
- 6: Behälter
- 7: Einlaufstern
- 8: Auslaufstern
- 9: Greifer
- 10: Neckring
- 11: Überführungselement
- 12: Transportstern
- 13: Vorsprung
- 14: Anlagefläche
- 15a, 15b: Führungsschienen

## Patentansprüche

1. Beschichtungsanlage mit einer Beschichtungsvorrichtung, welche ein rotierbar antreibbares Beschichtungsrad (1) sowie eine vorgelagerte Einlaufanordnung (2) und eine dem Beschichtungsrad (1) nachgelagerte Auslaufanordnung (3) aufweist, welche gemeinsam dazu eingerichtet sind, Behälter (6) jeweils entlang eines Abschnittes einer Transportstrecke zu transportieren, wobei das Beschichtungsrad (1) eine Vielzahl von in Umfangsrichtung angeordneten Behälteraufnahmen (5) und jeweils eine den Behälteraufnahmen (5) zugeordnete Beschichtungseinheit (4) aufweist, wobei die Beschichtungseinheit (4) dazu eingerichtet ist, die Behälter (6) während des Transports zu beschichten und wobei entlang der Transportstrecke zumindest ein Leitelement vorgesehen ist,
**dadurch gekennzeichnet, dass**
das Leitelement zumindest abschnittsweise eine Keramikbeschichtung aufweist.

2. Beschichtungsanlage nach Anspruch 1, **dadurch gekennzeichnet, dass** mehrere Leitelemente entlang der Transportstrecke vorgesehen sind, welche jeweils zumindest abschnittsweise eine Keramikbeschichtung aufweisen.

3. Beschichtungsanlage nach einem der vorangegangenen Ansprüche, **dadurch gekennzeichnet, dass** das Leitelement zumindest eine Anlagefläche (14) zum Leiten der Behälter (6) aufweist und wobei die Keramikbeschichtung zumindest auf der Anlagefläche (14) angeordnet ist.

4. Beschichtungsanlage nach einem der vorangegangenen Ansprüche, **dadurch gekennzeichnet, dass** zumindest ein Leitelement als Führungsschiene (15a, 15b) zum Führen der Behälter (6) entlang eines Abschnittes der Transportstrecke ausgebildet ist.

5. Beschichtungsanlage nach Anspruch 4, **dadurch gekennzeichnet, dass** zumindest zwei zueinander beabstandete Führungsschienen (15a, 15b) entlang des Abschnittes der Transportstrecke angeordnet sind.

6. Beschichtungsanlage nach Anspruch 4 oder 5, **dadurch gekennzeichnet, dass** das als Führungsschiene (15a, 15b) ausgebildete Leitelement in einem Abschnitt der Transportstrecke in der Einlaufanordnung (2) und/oder an der Auslaufanordnung (3) angeordnet ist.

7. Beschichtungsanlage nach einem der vorangegangenen Ansprüche, **dadurch gekennzeichnet, dass** zumindest ein Leitelement als Überführungselement (11) zum Ein- oder Ausweisen von Behältern (6) ausgebildet ist.

8. Beschichtungsanlage nach Anspruch 7, **dadurch gekennzeichnet, dass** das als Überführungselement (11) ausgebildete Leitelement zwischen dem Beschichtungsrad (1) und der Einlaufanordnung (2) oder der Auslaufanordnung (3) angeordnet ist.

9. Beschichtungsanlage nach Anspruch 7 oder 8, **dadurch gekennzeichnet, dass** die Einlaufanordnung (2) und/oder die Auslaufanordnung (3) aus jeweils zwei hintereinander entlang der Transportstrecke angeordneten Transportsternen (12) gebildet ist, wobei das als Überführungselement (11) ausgebildete Leitelement zwischen den Transportsternen (12) angeordnet ist.

10. Beschichtungsanlage nach einem der vorangegangenen Ansprüche, **dadurch gekennzeichnet, dass** das zumindest eine Leitelement aus Edelstahl und/oder Aluminium gebildet ist.

11. Beschichtungsanlage nach einem der vorangegangenen Ansprüche, dass die Keramikbeschichtung aus Chromnitrid gebildet ist.

12. Beschichtungsanlage nach einem der vorangegangenen Ansprüche, **dadurch gekennzeichnet, dass** die Keramikbeschichtung eine Dicke zwischen 5 und 15 µm aufweist.
